(19) Europäisches Patentamt
European Patent Office
Office européen des brevets

(11) **EP 1 010 332 B1**

(12) **EUROPÄISCHE PATENTSCHRIFT**

(45) Veröffentlichungstag und Bekanntmachung des Hinweises auf die Patenterteilung:
**26.03.2003 Patentblatt 2003/13**

(21) Anmeldenummer: **97948694.1**

(22) Anmeldetag: **30.10.1997**

(51) Int Cl.7: **H04N 9/04**

(86) Internationale Anmeldenummer:
**PCT/DE97/02527**

(87) Internationale Veröffentlichungsnummer:
**WO 98/019270 (07.05.1998 Gazette 1998/18)**

(54) **LICHTEMPFINDLICHE SENSOREINHEIT FÜR EINE ELEKTRONISCHE KAMERA, MIT EINER FLÄCHIGEN ANORDNUNG VON BILDPUNKTEN SOWIE VERFAHREN ZUM AUSLESEN DER BILDPUNKTE ZUR FARBSIGNALVERARBEITUNG**

LIGHT SENSITIVE SENSOR UNIT FOR AN ELECTRONIC CAMERA WITH A FLAT ARRANGEMENT OF PIXELS AND A METHOD OF READING PIXELS FOR COLOUR SIGNAL PROCESSING

UNITE DE DETECTION PHOTOSENSIBLE POUR UN APPAREIL PHOTO, AVEC UNE DISPOSITION PLANE DE PIXELS ET PROCEDE DE LECTURE DES PIXELS POUR UN TRAITEMENT DES SIGNAUX CHROMATIQUES

(84) Benannte Vertragsstaaten:
**AT BE CH DE DK ES FI FR GB GR IE IT LI LU MC NL PT SE**

(30) Priorität: **31.10.1996 DE 19644096**
**08.01.1997 DE 19700381**

(43) Veröffentlichungstag der Anmeldung:
**21.06.2000 Patentblatt 2000/25**

(73) Patentinhaber: **INSTITUT FÜR MIKROELEKTRONIK STUTTGART**
**70569 Stuttgart (DE)**

(72) Erfinder:
• **SEGER, Ulrich**
**D-71106 Magstadt (DE)**
• **APEL, Uwe**
**D-72666 Neckartailfingen (DE)**
• **HÖFFLINGER, Bernd**
**D-70569 Stuttgart (DE)**
• **GRAF, Heinz-Gerd**
**D-71106 Magstadt (DE)**

(74) Vertreter: **Münich, Wilhelm, Dr.**
**Anwaltskanzlei Dr. Münich & Kollegen,**
**Wilhelm-Mayr-Strasse 11**
**80689 München (DE)**

(56) Entgegenhaltungen:
**EP-A- 0 618 737          EP-A- 0 757 497**
**US-A- 4 580 160**

• **HYNECEK, JAROSLAV: "BCMD - an improved photosite structure for high-density image sensors" IEEE TRANSACTIONS ON ELECTRON DEVICES, Bd. 38, Nr. 5, 1.Mai 1991, (USA), Seiten 1011-1020, XP000200655 in der Anmeldung erwähnt**
• **PARULSKI, KENNETH A.: "Color Filters and Processing Alternatives for One-Chip Cameras" IEEE TRANSACTIONS ON ELECTRON DEVICES, Bd. ED-32, Nr. 8, 1.August 1985, (USA), Seiten 1381-1389, XP002061609 in der Anmeldung erwähnt**

**Beschreibung**

Technisches Gebiet

Die Erfindung bezieht sich auf eine Lichtempfindliche Sensoreinheit für eine elektronische Kamera, mit einer flächigen, Spalten und Zeilen aufweisenden, gitterförmigen Anordnung von Bildpunkten, die mittels eines Adressdecoders einzeln adressierbar sind und die spaltenweise mit Leseleitungen verbunden und über eine Ausleseeinheit auslesbar sind.

Insbesondere wird ein Bildsensor mit einer Bildpunkteanordnung beschrieben, die dazu geeignet ist, analoge Signalverarbeitungsschritte der Bildaufbereitung und -auswertung im Sensorbaustein durchzuführen. Eine konfigurierbare digitale Ansteuerlogik in Zusammenhang mit einem wahlfrei zugreifbaren Sensorarray und der Einrichtung mehrerer paralleler Signalpfade macht die Helligkeitsinformation für jeden Farbkanal für jeden einzelnen Bildpunkt gleichzeitig verfügbar. Ein Farbkanal wird dabei direkt aus dem Bildpunkt, die beiden anderen durch Interpolation aus den direkten Nachbarn abgeleitet. Dies legt die Grundlage für verschiedene analoge "On-Chip"-Signalverarbeitungsfunktionen.

Stand der Technik

Zur Aufnahme von Farbbildern mit Halbleiter-Sensoren werden mehrere Verfahren angewandt. Die Verfahren unterscheiden sich aufgrund unterschiedlicher zugrundeliegender Sensorstrukturen (CCD_IT, CCD_FT, CIT, CMOS_xy ...), ihrer Adressierungsmöglichkeiten (linear-, random-, Multipixelacces), ihrer Farbfiltertechnik (RGB, CMY, CMYW ...) -Anordnung (orthogonal, hexagonal) und Form (Quadrat-Pixel, Rechteck-Pixel) und nicht zuletzt auch durch das vorgeschaltete optische Abbildungssystem (Strahlteiler, Monocular+Filterrad) oder im System integriertes Beleuchtungssystem (z.B. stroboskopisch farbige Beleuchtung).

Gemeinsam ist diesen Verfahren der Farberfassung, daß zur Detektion ein a priori monochromatischer Chipsensor verwendet wird, wobei die "Farbaufspaltung durch die "Erfassung" eines Bildes in mehreren, z.T. überlappenden spektralen Kanälen durchgeführt wird. Die Berechnung des Farbwertes (d.h. die Lage eines Farbwertes in einem 3dim. Farbraum) erfolgt anschließend i.d.R. außerhalb des Sensor-Bausteins.

Die einfachste Methode, ein Farbbild zu gewinnen, ist die Verwendung eines rotierenden Filterrades mit den unterschiedlichen Farbfiltern im optischen Strahlengang. Dieses Verfahren bietet auch das beste "Cositing", d.h. Übereinstimmung von gemessenem Farbwert und dem Ort des Meßpunktes, da ein und derselbe Bildpunkt für die sequentielle Erfassung in verschiedenen Farbkanälen verwendet wird und sich Fehler in allen Kanälen gleich auswirken. Diese Aufnahmetechnik ist jedoch aufgrund der damit erreichbaren Aufnahmegeschwindigkeit (begrenzt durch die Filterrad-Geschwindigkeit und die Notwendigkeit, mehrere Farbauszüge sequentiell zu erstellen) weniger gut für die Bewegtbildaufnahme geeignet.

Ähnliches gilt für Kamerasysteme, weiche mit stroboskopischer farbiger Beleuchtung arbeiten. Derartige Systeme sind jedoch fremdlichtempfindlich und deshalb nur im Nahfeld, möglichst ohne Fremdlicht, einsetzbar. (Bspw. Endoskopie).

Die beste Farbauflösung bei der Bewegtbildanalyse erreichen Kamerasysteme mit 3-Chip - Anordnung, welche jeden Punkt des Objektraumes auf drei od. 4 Sensormatrizen verteilen, jeden optischen Kanal separat filtern und so zu drei bzw. vier unterschiedlichen zeitgleich aufgezeichneten Repräsentationen desselben Bildpunktes (objektbezogen) führen.

Ebenfalls sehr gute Ergebnisse erreichen Farbscannersysteme mit je einer getrennten Zeile für jeden Farbkanal, welche mit mehreren, mit unterschiedlichen Farbfiltern belegten Sensoren eine Szene im Zeitmultiplex aufnehmen

Die kostengünstigste Realisierung von Farbsensoren, gleichzeitig aber qualitativ minderwertigste Ausführung ist die Einchiplosung mit Farbmosaikfiltern, bei der die Farbbildpunkte durch das Aufbringen einer mosaikartig strukturierten Filterschicht unmittelbar auf die Sensorzellen gebildet werden. Diese Realisierung wird aber aufgrund der Herstellkosten in nahezu allen Niedrigpreisanwendungen favorisiert. Dabei wird eine Unterabtastung des Chrominanzwertes in Kauf genommen.

Für die numerische Beschreibung von Farbwerten werden bislang im wesentlichen folgende Farbmodelle verwendet:

- RGB-Farbmodell
- CMYK- oder CMY- Farbmodell
- HSV-Farbmodell

Jedes dieser Farbmodelle erfordert die Reprasentation eines Abbildes in verschiedenen Farbauszugsbildern, die zur Deckung gebracht werden müssen und aus welchen ein Farbwert für jeden Ortspunkt auf dem Sensor zugeordnet werden muß. Dazu werden, wie o.g. z.B. Farbfilter (CFA color filter arrays) auf den Sensor aufgebracht und lithografisch strukturiert, so daß die Signale einzelner Sensorpunkte einem "Farbkanal" zugeordnet werden können. Die Signale mehrerer Sensorzellen müssen dann miteinander verrechnet werden.

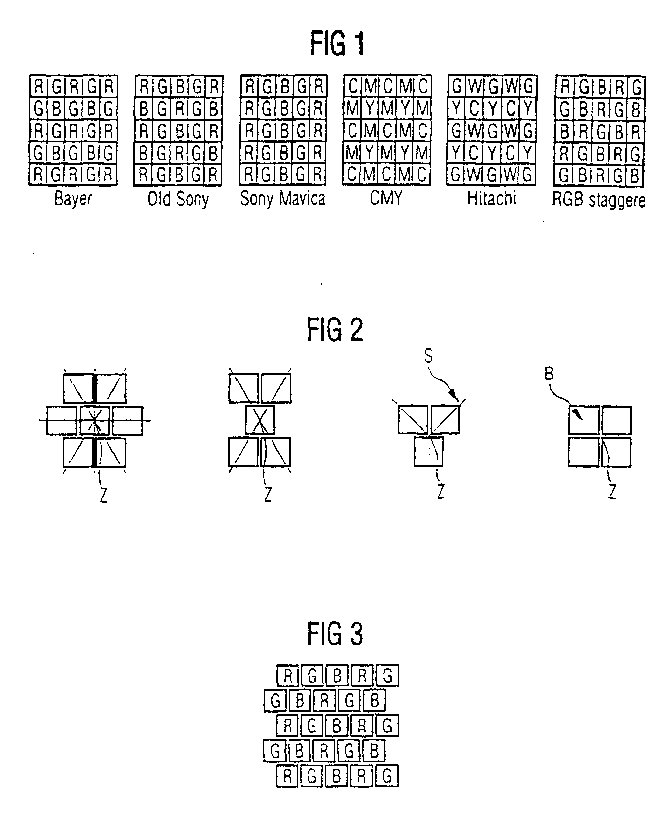

Gängige Farbfiltersysteme sind das Bayer-Muster, das Old Sony Muster, das SONY Mavica-Filter, das CMY-Muster, das Hitatchi-Muster und ein generisches RGB(Staggered) Muster (siehe Figur 1. in der beschriebenen Reihenfolge von links nach rechts).

Die zugrundeliegende Sensoranordnung ist in nahezu allen Fällen eine orthogonale Matrix mit weitgehend linear arbeitenden Sensorzellen.

Ein Maß für die Güte eines Mosaikmusters ist das sog. "Cositing" d.h. die Güte, mit der die errechneten Farbauszugsmuster zur Deckung gebracht werden können. Sind Farbpunkte nicht exakt zur Deckung zu bringen, so resultieren bei der Abbildung von Kanten Farbsäume, die sich störend auswirken. Diese Farbsäume entstehen auch bei Kameras mit Filterrad. wenn sich die Szene so schnell ändert, daß sich zwischen der Auslesung des ersten und des darauffolgenden Farbauszuges bereits eine Verschiebung von Objekten ergeben hat.

Bekannte Farbfiltersystem sind bspw. in den nachfolgenden Beiträgen beschrieben: M.A. Kriss,"Color Filter Arrays for Digital Electronic Still Cameras",Proceedings of IS&T's 49th Annual Conference, Seite 272-278, 1995; Jaroslav Heynecek, BCMD-An Improved Photosite Structure for High-Density Image Sensors, IEEE Transaction on Electron Devices, Vol 38, No. 5, Seite 1011-1020, Mai 1991; John E. Greivenkamp, Color dependent opticai prefilter for the suppression of aliasing artifacts". Applied Optics / Vol. 29, No.5, Feb. 1990; und K.A.Parulski, "Color Filters and Processing Alternatives for One-Chip Cameras",IEEE Transaction on Electron Devices, Vol. ED-32. No.8. Seite 1381-1389. August 1985.

So wird in Hynecek, "BCMD ..." eine verbesserte Struktur eines Bildsensors vorgeschlagen. Hierin werden neuartige BCMD Fotozellen eingesetzt, welche dicht gepackt in Sechsecken angeordnet werden können. Das Auslesen der Sensoren erfolgt entsprechend dem Stand der Technik zeilenweise.

Weiterhin wird in Parulsky, "Color Filters ..." die Auswahl geeigneter Filter- Anordnungen zur Farbdarstellung für einzelne Halbleiter-Bild Sensoren beschrieben. Darin werden insbesondere die zuvor zitierte Bayer- Filteranordnung sowie eine modifizierte Bayer-Filteranordnung mit der Hitachi-Filteranordnung verglichen.

Darstellung der Erfindung

Der Erfindung liegt die Aufgabe zugrunde, eine lichtempfindliche Sensoreinheit für eine elektronische, vorzugsweise farbfähige Kamera mit einer flächigen Anordnung von Bildpunkten derart auszugestalten, daß die Farbsignalauswertung schneller und mit erhöhter Qualität möglich sein soll. Insbesondere soll die Sensoreinheit die schnelle Signalverarbeitung von HDRC-Bildsensoren, also lichtempfindlichen Sensoren, deren Ausgangskennlinie logarithmisch verläuft, weitgehend vollständig nutzen Schließlich soll ein Verfahren zur integrierten Signalaufbereitung angegeben werden, welches sich auf eine variable Bildsensorarchitektur abstützt und eine schnelle Signalverarbeitung erlaubt.

Die Lösung der Erfindung ist im Anspruch 1 angegeben, in dem eine lichtempfindliche Sensoreinheit beschrieben ist. Ein erfindungsgemäßes Verfahren ist Gegenstand des Anspruchs 19 Den Erfindungsgedanken vorteilhaft weiterbildende Merkmale sind Gegenstand der Unteransprüche.

Zur zeitgleichen Auslesung von Bildpunkten, die in einer Spalte angeordnet sind, ist es nötig, wenigstens zwei getrennte Leseleitungen pro Spalte vorzusehen. Unter dem Begriff Spalte ist hierbei jedoch nicht nur der streng lineare Falle von senkrecht untereinander angeordneten Bildpunkten gemeint, sondern es können auch Bildpunkt leicht versetzt untereinander angeordnet sein, die zu einer Spalte zu rechnen sind, wie es beispielsweise bei hexagonalen Gittern der Fall ist.

Das erfindungsgemäße Verfahren zum Auslesen- und Auswerten von Bildpunkten in der vorstehend beschriebenen lichtempfindlichen Sensoreinheit sieht eine parallele Adressierung von wenigstens einer Gruppe von Bildpunkten vor, die um einen ausgewählten Bildpunkt, dem zentralen Bildpunkt angeordnet ist, und liest zeitgleich mittels einer Ausleseeinheit die benachbarten Bildpunkte nach Farbklassenzugehörigkeit mit dem zentralen Bildpunkt aus.

Dem erfindungsgemäßen Verfahren liegt die Idee der parallelen Adressierung und Verarbeitung von Nachbarschaftsgruppen zu einem ausgewählten zentralen Bildpunkt zugrunde. Das Verfahrens bedient sich dabei einer Zerlegung einer Faltungsoperation - dertige Faltungs- bzw. Filteroperationen werden in der Bildverarbeitung und -auswertung häufig zur Kontrastverstärkung und zur Glättung benutzt - in eine Reihe von Bildpunktezugriffen, bei denen die entsprechend einer Faltungsmatrix gleichgewichteten Bildpunktgruppen jeweils gemeinsam adressiert werden und deren Ausgangswerte bereits während des Auslesevorgangs gemittelt und nachfolgend gewichtet werden. Eine Verarbeitung der Sensorausgangswerte erfolgt dann teilweise auf der Ausgangsleitung, teilweise in einer nachgeschalteten analogen oder digitalen Arithmetikeinheit, die eine Mittelung der Einzelzugriffe auf die Bildpunktgruppen durchführt.

Das Filterverhalten solcher aktiven Bildpunktsensoren kann durch Veränderung der Ausdehnung gleichgewichteter Bildpunktgruppen an verschiedene Faltungskerne angepaßt werden. Für ein Sensorarray mit orthogonaler Anordnung müssen dazu die Adressdekoder in x- und y-Richtung getrennt auf die unterschiedliche Anzahl gleichzeitig zu adressierender Bildpunkte-Nachbarn eingestellt werden.

Kurze Beschreibung der Zeichnungen

Die Erfindung wird nachstehend ohne Beschränkung des allgemeinen Erfindungsgedankens anhand von Ausführungsbeispielen unter Bezugnahme auf die Zeichnungen beschrieben. Es zeigen:

Fig. 1 Übersicht der klassischen Color Filteranordnungen verschiedender Hersteller,

Fig. 2 Bildpunktanordnungen mit zentralem Symmetriepunkt,

Fig. 3 Anordnung von Bildpunkten, die jeweils den unterschiedlichen Grundfarben zugeodnet sind,

Fig. 4 Prinzipdarstellung des erfindungsgemäßen Verlauf der Leseleitungen pro Spalte,

Fig. 5 Sequenzdarstellung zum Wechsel der Bildpunkte einer Auslesegruppe, die jeweils zeitgleich ausgelesen werden,

Fig. 6 parallelauslesbare Bildpunktegruppe in einer hexagonalen Gitteranordnung,

Fig. 7 Auslese- und Verarbeitungseinheit für hexagonale Bildpunkteanordnung, und

Fig. 8 Darstellung unterabgetasteter Gitterpunkte.

Darstellung von Ausführungsbeispielen

Figur 1 ist zur Darstellung der Übersicht bekannter klassischer Color Filteranordnugen bereits in der Beschreibungseinleitung beschrieben worden.

Dem erfindungsgemäßen Auslese- und Auswerteverfahren liegt vorzugsweise eine sternförmige Anordnung fotoempfindlicher, räumlich zusammenhändender Bildpunkte B als wiederkehrende, gleichgroße Untergruppierungen zugrunde (siehe Figur 2), welche auf einem Substrat liegen, die lichtempfindliche Fläche darstellen und zeitgleich ausgelesen werden können. Die sternförmige Anordnung wird gebildet durch ein Zentrum Z, das dem Schwerpunkt eines fiktiven oder realen Bildpunktes entspricht, von dem mehreren "Strahlen" S zu realen, auf einem regelmäßigen Gitter liegenden Bildpunkten derart ausgehen, daß die Lage der einzelnen Gitterpunkte mit Sensoren symmetrisch und äquidistant zum Zentrum gewählt wird.

Ein Farbmuster für die erfindungsgemäße, lichtempfindliche Sensoreinheit ist in Figur 3 dargestellt, das die Bildpunkte in einer Art hexagonalen Anordnung zeigt, wobei sich die Farbzugehörigkeiten für die Grundfarben Rot (R), Grün (G) und Blau (B) in der angegebenen Weise zyklisch abwechseln. Die Anordnung enstammt der Überlagerung zweier orthogonaler Gitter, die kammartig ineinander verschoben sind.

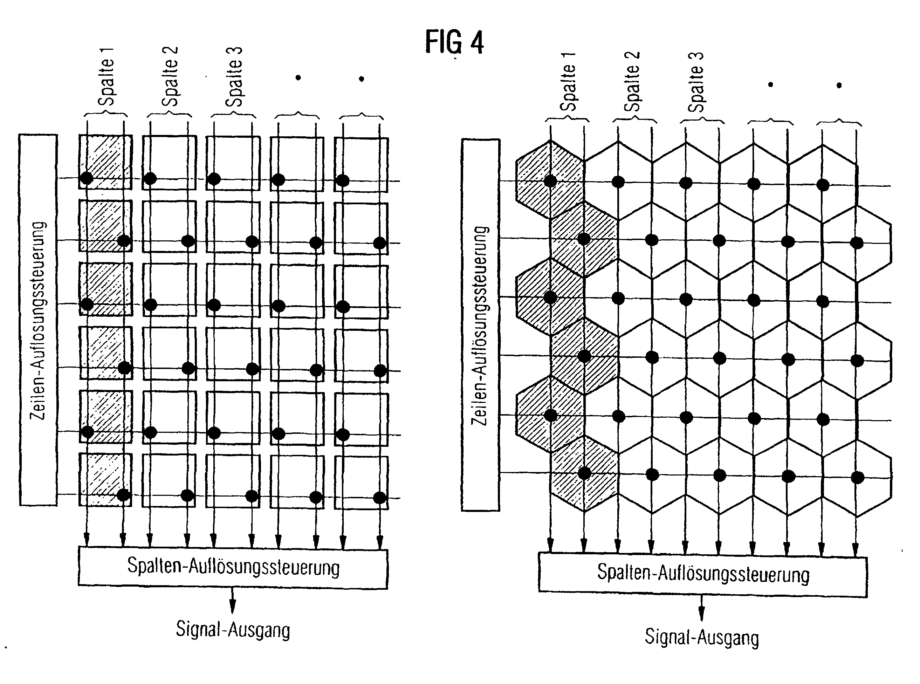

In Figur 4 ist eine erfindungsgemäße Zuteilung von zwei Leseleitungen pro Spalte für den Fall einer orthogonalen Gitteranordnung (siehe linke Bilddarstellung) sowie für den Fall einer hexagonalen Gitteranordnung (siehe rechte Bilddarstellung) von Bildpunkten dargestellt. Im orthogonalen Fall ist jeder Bildpunkt direkt mit jeweils zwei Leseleitungen verbunden, wohingegen im hexagonalen Fall durch die leicht versetzte Anordnung von Bildpunkten pro Spalte jeder Bilpunkt mit einer Leseleitung verbunden ist.

Zum Auslesen werden die Bildpunkte abwechselnd auf die Leseleitung für geradzahlige und ungeradzahlige Zeilennummern geschaltet, so daß jede Leseleitung jeweils nur die Hälfte der Bildpunkte pro Spalte erfaßt.

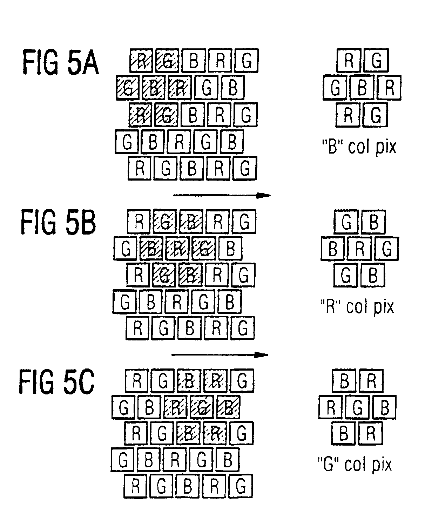

In Figur 5 sind jeweils die Bildpunkte, die für den Auslesevorgang zeitgleich adressiert sind und simultan ausgelesen werden, schattiert hinterlegt. So wird die Bildpunktegruppe im ersten Auslesevorgang (Fig. 5 a), die sich zyklisch um den zentralen Bildpunkt B gruppiert, gemeinsam mit dem zentralen Bildpunkt B ausgelesen.

In einem unmittelbar darauffolgenden Ausleseschritt wird die in der Propagationsrichtung (siehe Pfeil) nächstgelegene Bildpunktegruppe um den zentralen Bildpunkt R adressiert und ausgelesen u.s.w (siehe die Figuren 5 b und c).

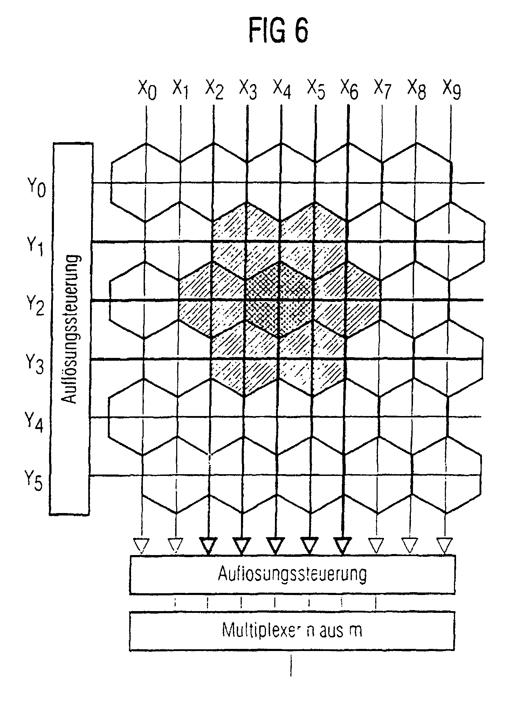

Für den speziellen Fall eines Sensorarrays mit hexagonaler Bildpunkteanordnung, die in Figur 6 dargestellt ist, sind die im folgenden beschriebenen Punkte für eine Auflösungssteuerung wichtig.

Mit der Verwendung von getrennten Spaltenleitungen ($x_0$, ..., $x_9$) für gerad- und ungeradzahlige Zeilen entsteht die Möglichkeit, gleichzeitig mit einem zentralen Bildpunkt den Ring der 6 nächsten Nachbarn zu adressieren. Dazu sind jeweils die benachbarte Zeile über und unter dem Zentralbildpunkt, sowie jeweils zwei Nachbarspalten rechts und links zusätzlich zu adressieren. Der hexagonale Aufbau erlaubt die Verwendung identischer Gewichtungskoeffizienten für alle gleichzeitig erfaßten Bildpunkte. Das Videosignal, das sich durch das Zusammenwirken mehrerer Verstärker einstellt, gibt nach Simulationen den mittleren Helligkeitswert über alle aktivierten aktiven Sensor-Bildpunkte wieder.

Die über die Ausleseleitungen ( in der Figur fett gedruckt) aus dem Array herausgeführten Videosignale sind mittels einer geeigneten, für die Anwendung und die Zellanordnung entsprechend ausgelegten Multiplexerschaltung M auf mehrere Verarbeitungskanäle durchzuschalten. Ein weiterer Vorteil der doppelten Auslegung der Ausleseleitung ergibt sich aus der fuer die einzelne Ausleseleitung halbierten Anzahl der MOS-Schalter und der damit verbundenen Knotenkapazitaeten. Damit faellt bei gleicher Treiberleistung im einzelnen Bildpunkt der Einschwingvorgang auf der Leseleitung nach dem Wechsel der adressierten Bildzeile deutlich kuerzer aus.

Für eine auf drei Spektralbereichen basierende Farbauswertung ergeben sich somit andere Mulitplexerkonfigurationen als z.B. für eine Tiefpassfilterung monochromer Bildinhalte. Verschiedene Auslegungen dieses Multiplexers M können durch Programmierung oder analog zu den Gate-Arrays durch eine gemeinsame Masterstruktur mit unterschiedlichen Personalisierungen hergestellt werden.

Da die in der HDRC-Technik verwendeten Sensoren prinzipiell eine hohe Ausleserate ermöglichen, können durch interne Parallelisierung die Auslesesignale analog ausgelesen und analog weitgehend verarbeitet werden. Auf die parallele Weiterverarbeitung wird noch an späterer Stelle eingegangen.

Die quasi hexagonale Anordnung bedingt, daß die ungeradzahligen Zwischenzeilen odd-rows) um eine halbe Bildpunktbreite gegen die geradzahligen Reihen (even-rows) nach links versetzt sind. Die erste Zeile mit der Indizierung 0 ist also gegen die Kante eingezogen. Durch den Einsatz von zwei getrennten Spaltenleitungen für die gleichen Bildpunktadressen in odd- und even-rows kann ein einheitliches Layout für alle Bildpunkte erzielt werden, damit ist trotz orthogonalem Layout die dichte Annäherung an ein echtes hexagonales Gitter gewährleistet.

Die zeitgleiche Adressierung von einem weiteren Bildpunkt-Ringen um den zentralen Bildpunkt kann im Randbereich nur dann störungsfrei aufrechterhalten werden, wenn das tatsächliche Sensorarray jeweils 1 Zeilen und 2 Spalten pro Seite mehr enthält, als für die Bilddarstellung verwendet werden (Randwertproblem bei Filtern).

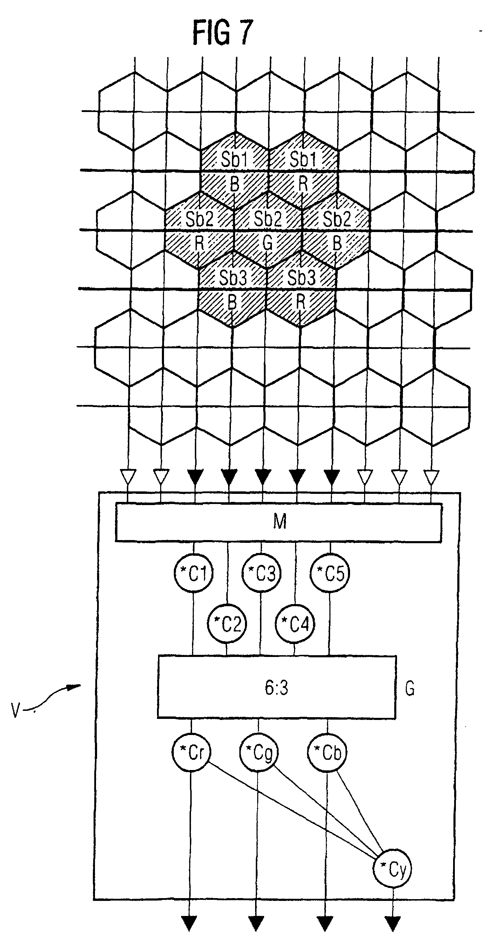

In Figur 7 ist die in Figur 6 angegebene hexagonale Bildpunkteanordnung erweitert mit einer schematisierten Auslese- und Verarbeitungseinheit dargestellt. Die Bilpunkteanordnung ermöglicht eine Spannungsmittelwertbildung der gepufferten Spannungsausgänge auf den Leseleitungen. Im Falle logarithmischer Eingangswerte ergibt sich mit guter Näherung das geometrische Mittel der Eingangswerte.

Eine spezielle Dekoderanordnung erlaubt die Selektion von j aus i Zeilen. Eine weitere Dekoderanordnung, die einen Multiplexer steuert, erlaubt durch geeignete Beschaltung die Auswahl von n aus m Leitungen. In Figur 7 werden, bspw. 5 der 10 dargestellten Leitungen ausgewählt und auf die Gewichtsschaitung $C_1$,..., $C_5$ aufgeschaltet.

Ferner ist eine Farbkanalgewichtungs und -Verarbeitungseinheit V vorgesehen, so daß die Ausgänge aller zeitgleich adressierter Bildpunkte parallel nach außen (zum Arrayrand) geführt werden und zeitgleich verarbeitet werden können.

In dem vorgegebenen Beispiel des hexagonal orientierten Sensors sind 5 Leitungen nötig um 7 Sensorpixel zeitgleich auszulesen. Eine Multiplexerlogik M zwischen Ausleseleitung und Gewichtungsnetzwerk G führt die jeweils adressierten Kanälen (bei Farbauswertung typischerweise 5 Kanäle) "ihren" Verstärkern zu. Das Gewichtungsnetzwerk G besteht hierbei aus 6 Kanälen mit z.T. unterschiedlichen Gewichtungskoeffizienten (*$C_1$...*$C_6$), von denen jeweils 5 gleichzeitig aktiv sind (2 "singles", hier auf *$C_1$ und *$C_5$ geschaltet, 2 "pairs" hier auf *$C_2$ und *$C_4$ geschaltet, 1 "center" hier auf *$C_3$ geschaltet). Bei Verwendung als farbfähiger Bildsensor muß die Anordnung des Farbmosaikfilters entsprechend der in Figur 3 gezeigten Abfolge gestaltet sein, die gewährleistet, dass die direkten Nachbarn des Bildpunktes einer Farbklasse ausschliesslich zu den anderen Farbklassen gehören.Die Kanalverstärker können online programmierbar ausgeführt werden, um die Gewichtung der Kanäle den verwendeten Mosaicfiltern anpassen zu können.

Der Sonderfall "keine Farbfilter" führt bei geeigneter Einstellung der Koeffizienten zu einer Tiefpassfilterung.

In einer weiteren Multiplexerstufe werden die 6 analogen Kanälen (je 2 für R,G,B) derart verschaltet, daß jeweils bis zu zwei Kanäle zusammengeschaltet werden können.

Im Fall der Farbsignalverarbeitung werden jeweils farbgleiche Signale (*$C_r$, *$C_g$, *$C_b$) zusammengefasst. Eine dritte Mittelungsstufe (*$C_y$) die alle drei Farbkanäle zusammenfasst, erzeugt ein Maß für die Luminanz des angewählten "Makropixels".

Die erfindungsgemäße Bildpunkte-Anordnung führt insbesondere zu folgenden Vorteilen:

Eine gute Farbbildwiedergabe kann mit geringen Farbstörungen durch verbessertes "Cositing" erreicht werden:
Für die Wiedergabe der Bildinformationen auf einem Display sind die Helligkeitswerte aller drei Farbkanäle für jeden Bildpunkt erforderlich. Bei der Bilderfassung durch Sensoren mit Farb-Mosaikfiltern steht für jeden Bildpunkt nur für einen Farbkanal der tatsächlich gemessene Wert zur Verfügung, die beiden anderen Farbwerte müssen durch Interpolation aus benachbarten Bildpunkten, die die entsprechende Farbmaskierung aufweisen, ermittelt werden. Das hier angesprochene ideale Cositing bedeutet, daß eine gute Übereinstimmung der Schwerpunktlage der für die Interpolation herangezogenen verschiedenfarbigen Bildpunkte besteht.

Im Fall eines exakt hexagonalen Arrays (Zeilen- und Spaltenpitch sind nicht gleich groß) ist der Schwerpunkt jedes diskreten Farbbildpunktes identisch mit den Schwerpunkten der beiden komplementären, aus jeweils drei direkte benachbarten Pixeln berechneten, virtuellen Farbbildpunkte. Im Fall eines ineinadergeschobenen orthogonalen Array (quasi hexagonal, dafür identische Zeilen- und Spaltenpitches) werden geringe Abweichungen (< 1/8 c mit c=Gitterkonstante) erreicht. Im Gegensatz dazu weicht bei bisher bekannten Farbmosaikfiltern der virtuelle Schwerpunkt des Farb-n-Tupels um mind. $c \cdot \sqrt{2}$ von dem Schwerpunkt der einzelnen Farbbild punkte ab.

Eine aufwendige Zwischenspeicherung analoger Werte, die bei den bekannten Sensoren, die nur eine streng einzeilige Adressierungen erlauben, zur Berechnung von Farbinformationen zwingend erforderlich ist, ist nicht mehr nötig. Bildpunkte mit identischen Spaltenindizes von gerad- und ungeradzahligen Zeilen werden jeweils über eigene Spaltenleitungen ausgelesen und über eine geeignete, flexible Multiplexerstruktur auf den Videobus mit 6 parallelen Kanälen (RGB jeweils für gerad- oder ungeradzahlige Zeilen) übertragen. Bei einer gleichzeitigen Adressierung von bis zu 3 Zeilen können somit die Bildinformation der 3 Farbpixelgruppierungen des betreffenden Sterns getrennt über eigene Auslesekanäle bearbeitet (gewichtet, gemittelt) werden.

Eine Unterabtastung mit gleichzeitiger Umsetzung von hexagonale auf orthogonale Abtastgitter ist möglich: Eine Kompression der Datenmengen ist für die Übertragung von Bildinformationen über Kanäle mit geringerer Bandbreite (z.B. Bildtelephonie) oder für die Datenspeicherung wichtig. Die erfindungsgemäß vorgestellte Bildpunktanordnung zusammen mit dem Multiplexerschema ermöglicht einen Betriebswechsel des Sensors zwischen komprimierter Bilddatenausgabe (mit den entsprechenden Auflösungsverlusten) und der Vollbildauflösung. Für die Kompression der Bilddaten kann z.B. in jeder geradzahligen Zeile jeder 2. Bildpunkt adressiert werden. Zusätzlich zu den durch die jeweilige Farbfilterschicht ermittelten tatsächlichen Farbwerten werden die interpolierten Farbwerte aus den direkt anschliessenden Zellen mit den komplementären Farbfilterbeschichtungen ausgegeben. Die geometrische Anordung der ausgelesen Bildpunkte liegt in diesem Fall auf einem orthogonalen Untergitter.

Zur Vermeidung typischer Unterabtastungseffekte (aliasing) muß das Signal tiefpaßgefiltert werden. Diese Tiefpaßfilterung sollte eine Kohärenzlänge aufweisen, die größer oder gleich dem halben Gitterabstand des unterabgetasteten Gitters ist.

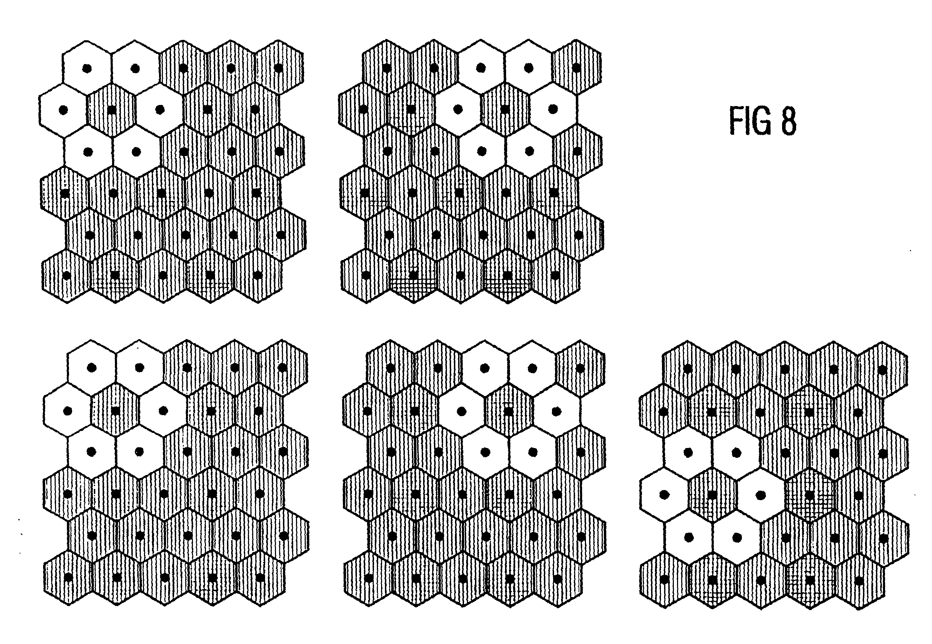

In Figur 8 obere Bildpunkteanordnung ist eine Beispiel für eine derartige Unterabtastung auch Subsampling genannt mit Tiefpassfilterung dargestellt. Die schwarzen Bildpunkte stellen die Punkte des unterabgetasteten Gitters dar, die hellen Bildpunkte zeigen die jeweils in die Bewertung eines neuen Gitterpunktes einbezogenen Bildpunkte des ursprünglichen Gitters. Bei Anwendung des ,staggered hex RGB"-Patterns führt diese Form der Unterabtastung erneut auf ein staggered hex RGB Pattern mit 1/4 der Datenmenge. Da alle Flächenelemente bzw. Bildpunkte der vollen Matrix berücksichtigt werden, ist die Moire-Neigung gegenüber einer einfachen Unterabtastung (durch exklusives Auslesen der dunklen Elemente) deutlich verringert.

Die untere Bildpunktanordnungen stellen ein Beispiel für eine Unterabtastung mit einer Gittertransformation dar. Aus dem staggered hex RGB-Pattern wird durch Unterabtastung ein Pattern entsprechend dem orthogonalen SONY MAVICA Pattern. Diese Transformation ist besonders dann sinnvoll, wenn ein Display entsprechend der Sony Mavica-Farbmatrix zur Verfügung steht. Bilder jedoch mit einer staggered hex Kamera aufgenommen worden sind.

### BEZUGSZEICHENLISTE

B  Bildpunkt
Z  Zentrum eines Schwerpunktes
S  Strahlrichtung einer Symmetrielinie
M  Multiplexerschaltung
V  Verarbeitungseinheit

G  Gewichtungsnetzwerk

### Patentansprüche

**1.** Lichtempfindliche Sensoreinheit für eine elektronische Kamera, mit einer flächigen, Spalten und Zeilen aufweisenden, gitterförmigen Anordnung von Bildpunkten, die mittels eines Adressdecoders einzeln adressierbar sind und die spaltenweise mit Leseleitungen verbunden und über eine Ausleseeinheit auslesbar sind, wobei in jeder Spalte wenigstens zwei Leseleitungen vorgesehen sind, die mit, in der jeweiligen Spalte angeordneten Bildpunkten sowie mit einer Ausleseeinheit verbunden sind, so daß ein ausgewählter, zentraler Bildpunkt elektrisch unabhängig von und zeitgleich mit benachbarten Bildpunkten, die zusammen eine Gruppe bilden, auslesbar ist,
**dadurch gekennzeichnet, daß**
die Zahl der zeitgleich auslesbaren benachbarten Bildpunkte sechs ist, und daß die Bildpunkte derart ausgebildet und angeordnet sind, daß der Schwerpunkt des zentralen Bildpunkts mit dem Schwerpunkt der zeitgleich auslesbaren benachbarten Bildpunkte zusammenfällt.

**2.** Lichtempfindliche Sensoreinheit nach Anspruch 1, **dadurch gekennzeichnet, daß** die Bildpunkte einen Spannungsausgang aufweisen, der mit einer Leseleitung verbunden ist, und daß eine Signalmittelung der zeitgleich auf einer Leseleitung ausgelesenen Bildpunkte erfolgt.

**3.** Lichtempfindliche Sensoreinheit nach Anspruch 1 oder 2, **dadurch gekennzeichnet, daß** einzelne Bildpunkte, die in einer gemeinsamen Spalte angeordnet sind und über einen gleichen Gewichtungsfaktor verfügen, der für jeden Bildpunkt festgelegt ist, mit einer gemeinsamen Leseleitung auslesbar sind.

**4.** Lichtempfindliche Sensoreinheit nach Anspruch 3, **dadurch gekennzeichnet, daß** jede Leseleitung mit einer Gewichtungsschaltung verbunden ist, in der die Gewichtung der ausgelesenen Bildpunkte erfolgt.

**5.** Lichtempfindliche Sensoreinheit nach einem der Ansprüche 2 bis 4, **dadurch gekennzeichnet, daß** die Signalmittelung bei Verwendung logarithmisch arbeitender Bildpunkte dem geometrischen Mittelwert der Helligkeiten entspricht.

**6.** Lichtempfindliche Sensoreinheit nach Anspruch 4 oder 5,

**dadurch gekennzeichnet, daß**
die Leseleitungen über einen n aus m Multiplexer auf die Gewichtungsschaltung durchgeschaltet werden.

7. Lichtempfindliche Sensoreinheit nach einem der Ansprüche 4 bis 6,
**dadurch gekennzeichnet, daß**
die Gewichtungsschaltung eine erste Gewichtungsstufe aufweist, in der eine Multiplikation des ausgelesenen Signals mit der Anzahl der auf der Leseleitung angeschlossenen Bildpunkte sowie mit einem Faktor, der der Stellung der in der Gruppe zeitgleich ausgelesener Bildpunkte entspricht, erfolgt.

8. Lichtempfindliche Sensoreinheit nach einem der Ansprüche 2 bis 7,
**dadurch gekennzeichnet, daß**
ein Multiplexer vorgesehen ist, der die Leseleitungen der benachbart, vorzugsweise konzentrisch um den zentralen Biidpunkt gelegenen Bildpunkte, zusammenschaltet und eine Mittelung punktsymmetrisch zum zentralen Bildpunkt gelegener Bildpunkte ermöglicht.

9. Lichtempfindliche Sensoreinheit nach einem der Ansprüche 1 bis 8,
**dadurch gekennzeichnet, daß**
die Bildpunkte für den Aufbau einer farbfähigen Kamera den Grundfarben Rot, Grün und Blau zugeordnet sind,
die Bildpunktanordnung und die Farbzuordnung zu den einzelnen Bildpunkten derart gewählt ist, daß der zentrale Bildpunkt einer Grundfarbe jeweils von Bildpunkten der anderen Grundfarben unmittelbar benachbart ist,
die Bildpunkte in einer geometrisch streng zyklischen Abfolge hinsichtlich ihrer Farbzuordnung angeordnet sind,
die streng zyklische Abfolge der Farbzuordnung jeweils benachbarter Bildpunkte in allen Symmetrierichtungen, die durch die geometrische Anordnung der Bildpunkte vorgegeben ist, gegeben ist und
die Gewichtungsschaltung eine zweite Gewichtungsstufe aufweist, die eine Gewichtung getrennt nach Farbklassen durchführt.

10. Lichtempfindliche Sensoreinheit nach Anspruch 9,
**dadurch gekennzeichnet, daß**
die Signale der gewichteten Farbklassen getrennt voneinander einer Weiterverarbeitungseinheit zugeführt werden, in der zur Bildung eines Bildpunktgruppensignals die Signale der einzelnen Farbklassen gewichtet und gemittelt werden.

11. Lichtempfindliche Sensoreinheit nach Anspruch 1 bis 10,
**dadurch gekennzeichnet, daß**
die Bildpunkte gemäß einer hexagonalen Gitterstruktur angeordnet sind.

12. Lichtempfindliche Sensoreinheit nach Anspruch 11,
**dadurch gekennzeichnet, daß**
die Bildpunkte derart ausgebildet und angeordnet sind, daß der Schwerpunkt des zentralen Bildpunktes mit einem gemeinsamen Schwerpunkt zusammenfällt, welcher durch die dem zentralen Bildpunkt unmittelbar benachbarten Bildpunkte, die jeweils der gleichen Farbklasse angehören, definiert ist.

13. Lichtempfindliche Sensoreinheit nach einem der Ansprüche 1 bis 3,
**dadurch gekennzeichnet, daß** die Bildpunkte eine quadratische, rechteckige oder hexagonale Form aufweisen.

14. Lichtempfindliche Sensoreinheit nach Anspruch 13,
**dadurch gekennzeichnet, daß**
die Anordnung der einzelnen Bildpunkte einer Gitterstruktur entspricht, die sich aus einer Überlagerung zweier kammförmig ineinandergeschobener, orthogonaler Gitter ergibt.

15. Lichtempfindliche Sensoreinheit nach einem der Ansprüche 9 bis 14,
**dadurch gekennzeichnet, daß**
zur Farbzuordnung der Bildpunkte unterschiedliche, den Grundfarben entsprechende Filterschichten vorgesehen sind.

16. Lichtempfindliche Sensoreinheit nach einem der Ansprüche 1 bis 15,
**dadurch gekennzeichnet, daß**
die Sensoreinheit aus HDRC-Sensoren zusammengesetzt ist mit Bildpunkten, deren Ausgangssignale einer logarithmischen Kennlinie unterliegen.

17. Lichtempfindliche Sensoreinheit nach Anspruch 16,
**dadurch gekennzeichnet, daß**
die HDRC-Sensoren auf einem Trägersubstrat aufgebracht sind und an ihrer dem Trägersubstrat zugewandten Seite eine reflexmindernde Schicht aufweisen.

18. Lichtempfindliche Sensoreinheit nach einem der Ansprüche 11 bis 17,
**dadurch gekennzeichnet, daß**
eine Bildpunktgruppe aus einem 7-Tupel besteht, das über 5 spaltenförmig angeordnete Leseleitungen und über 3 zeilenförmig angeordnete Selektleitungen verfügt.

19. Verfahren zum Auslesen- und Auswerten von Bildpunkten in einer lichtempfindliche Sensoreinheit nach einem der Ansprüche 9 bis 18,
**dadurch gekennzeichnet, daß**
eine parallele, zeitgleiche Adressierung von wenigstens einer Gruppe von Bildpunkten vorgenommen wird, die um einen ausgewählten Bildpunkt, dem zentralen Bildpunkt angeordnet ist, und daß eine Ausleseeinheit zeitgleich die benachbarten Bildpunkte nach Farbklassenzugehörigkeit mit dem zentralen Bildpunkt ausliest, wobei die Zahl der zeitgleich auslesbaren benachbarten Bildpunkte sechs ist und die Bildpunkte derart ausgebildet sind, daß der Schwerpunkt des zentralen Bildpunkts mit dem Schwerpunkt der zeitgleich auslesbaren benachbarten Punkte zusammenfällt.

20. Verfahren nach Anspruch 19,
**dadurch gekennzeichnet, daß**
die Gruppe aus Bildpunkten besteht, die jeweils einen gemeinsamen Schwerpunkt aufweisen, der mit dem Schwerpunkt des zentralen Bildpunktes übereinstimmt oder zumindest nahe dem Schwerpunkt des zentralen Bildpunktes liegt.

21. Verfahren nach Anspruch 19 oder 20,
**dadurch gekennzeichnet, daß**
die Bildpunktwerte, der gemeinsam adressierten Bildpixel während des Auslesevorganges gemittelt werden.

22. Verfahren nach einem der Ansprüche 19 bis 21,
**dadurch gekennzeichnet, daß**
durch einen digitaler Dekoder die Bildpunkte gezielt adressiert werden.

23. Verfahren nach Anspruch 22,
**dadurch gekennzeichnet, daß**
die Größe und Anzahl der zu adressierenden Gruppen von Bildpunkte durch den Dekoder festgelegt wird.

24. Verfahren nach einem der Ansprüche 19 bis 23,
**dadurch gekennzeichnet, daß**
bei einer Bildpunktanordnung, bei der die Bildpunkte einer Zeilen- und Spalteneinteilung unterliegen, alle Bildpunkte in einer Spalte oder einer Zeile getrennt jeweils über eine Spalten- oder Zeilenleitung adressiert werden.

25. Verfahren nach Anspruch 24,
**dadurch gekennzeichnet, daß**
einen gezielte und getrennte Adressierung von Spalten- oder Zeilenleitungen mittels einer Dekoderschaltung erfolgt.

26. Verfahren nach einem der Ansprüche 19 bis 25,
**dadurch gekennzeichnet,** daß
für die Adressierung eines weiteren zentralen Bildunktes in einer vorgegebenen Propagationsrichtung, in Propagationsrichtung neue Bildpunkte zu adressieren sind und entgegengesetzt angeordnete Bildpunkte der gleichen Farbklasse ersetzt werden.

27. Verfahren nach einem der Ansprüche 19 bis 26,
**dadurch gekennzeichnet,** daß
zum Auslesen eines zentralen Bildpunktes beliebig viele Nachbarschaftsgruppen von Bildpunkten um den zentralen Bildpunkt herum zusätzlich adressiert und ausgelesen werden, die ebenso einer strengen zyklischen Abfolge in der Farbzuordnung unterliegen.

28. Verfahren nach einem der Ansprüche 19 bis 27,
**dadurch gekennzeichnet, daß**
während des Auslesevorganges mit einer vorgegebenen Auslesefrequenz auf jeder Leseleitung eine mit einem einstellbaren Wert durchgeführte Gewichtung erfolgt.

29. Verfahren nach Anspruch 28,
**dadurch gekennzeichnet, daß**
die Gewichtung entsprechend der Anzahl der zeitgleich auf einer Leseleitung adressierten bzw. angeschlossenen Bildpunkte erfolgt.

30. Verfahren nach Anspruch 28 oder 29,
**dadurch gekennzeichnet, daß**
die Gewichtung durch einstellbare Koeffizienten getrennt für die Farbklassen durchgeführt wird.

**Claims**

1. Light sensitive sensor unit for an electronic camera, comprising a plane grid-shaped, column and row arrangement of pixels which can be addressed singly by means of an address decoder and which are connected column-wise with readout lines and can be read out via a readout unit, each column being provided with at least two readout lines that are connected with pixels disposed in the respective column and also with a readout unit, so that a selected central pixel may be read out electrically and independently from and simultaneously with adjacent pixels that jointly form a group,
**characterized in that**
the number of adjacent pixels that can be simultaneously read out is six, and that the pixels are designed and disposed in such manner that the centre of the central pixel coincides with the centre of configuration of the adjacent pixels that can be read out simultaneously.

2. Light sensitive sensor unit according to claim 1, **characterized in that** the pixels have a voltage output connected to a readout line, and that signal averaging is performed on the pixels that are read out simultaneously on a readout line.

3. Light sensitive sensor unit according to claim 1 or 2, **characterized in that** single pixels disposed in a common column and having the same weighting factor that is fixed for each pixel can be read out with a common readout line.

4. Light sensitive sensor unit according to claim 3, **characterized in that** each readout line is connected to a weighting circuit in which a weighting of the read out pixels is performed.

5. Light sensitive sensor unit according to any one of claims 2 to 4, **characterized in that** the signal averaging corresponds to the geometrical mean of the brightness values when logarithmically operating pixels are used.

6. Light sensitive sensor unit according to claim 4 or 5, **characterized in that** the readout lines are connected to the weighting circuit via an n of m multiplexer.

7. Light sensitive sensor unit according to any of claims 4 to 6, **characterized in that** the weighting circuit has a first weighting stage in which a multiplication is performed of the read out signal with the number of pixels connected to the readout line; and also with a factor corresponding to the position of the pixels simultaneously read out in the group.

8. Light sensitive sensor unit according to any one of claims 2 to 7, **characterized in that** a multiplexer is provided for connecting together the readout lines of the adjacent pixels, preferably located concentrically around the central pixel, and enabling an averaging of pixels located point-symmetrically to the central pixel.

9. Light sensitive sensor unit according to any one of claims 1 to 8, **characterized in that** the pixels for the design of a colour camera are assigned to the basic colours red, green, and blue; the pixel configuration and the assignment of colours to the individual pixels are selected so that each central pixel of a basic colour is directly adjacent to pixels of the other basic colours; the pixels are disposed in a geometric strictly cyclic sequence of the colour assignments; the strictly cyclic sequence of the colour assignments of respectively adjacent pixels is maintained along all directions of symmetry predetermined by the geometric configuration of the pixels; and the weighting circuit has a second weighting stage that performs a separate weighting according to colour classes.

10. Light sensitive sensor unit according to claim 9, **characterized in that** the signals of the weighted colour classes are supplied separately from each other to a further processing unit in which the signals of the respective colour classes are weighted and averaged to form a pixel group signal.

11. Light sensitive sensor unit according to any one of claims 1 to 10, **characterized in that** the pixels are disposed in accordance with a hexagonal grid structure.

12. Light sensitive sensor unit according to claim 11, **characterized in that** the pixels are designed and disposed in such manner that the centre of the central pixel coincides with a common centre of configuration defined by the pixels that are directly adjacent to the central pixel and belong to the same colour class.

13. Light sensitive sensor unit according to any one of claims 1 to 3, **characterized in that** the pixels are of a square, rectangular, or hexagonal shape.

14. Light sensitive sensor unit according to claim 13, **characterized in that** the configuration of the respective pixels corresponds to a grid structure resulting from a superposition of two orthogonal comb-like grids by intermeshing.

15. Light sensitive sensor unit according to any one of claims 9 to 14, **characterized in that** different filter layers corresponding to the basic colours are provided for colour assignment of the pixels.

16. Light sensitive sensor unit according to any one of claims 1 to 15, **characterized in that** the sensor unit is composed of HDRC sensors with pixels, the output signals from which are subject to a logarithmic characteristic.

17. Light sensitive sensor unit according to claim 16, **characterized in that** the HDRC sensors are mounted on a carrier substrate and have a reflection-reducing layer on the side facing the carrier substrate.

18. Light sensitive sensor unit according to any one of claims 11 to 17, **characterized in that** a pixel group consists of a septuplet having available 5 readout lines in column arrangement and 3 selector lines in row arrangement.

19. Method for reading out and evaluating pixels in a light sensitive sensor unit of any one of claims 9 to 18,
**characterized in that**
parallel simultaneous addressing is performed of at least one group of pixels disposed around a selected pixel that is the central pixel; and that a readout unit reads out the adjacent pixels according to their respective colour classes simultaneously with the central pixel; the number of adjacent pixels that can be simultaneously read out being six, and the pixels being designed in such manner that the centre of the central pixel coincides with the centre of configuration of the adjacent pixels that can be read out simultaneously.

20. Method according to claim 19,
**characterized in that** the group consists of pixels that have a common centre of configuration coinciding with the centre of the central pixel, or is at least located close to the centre of the central pixel.

21. Method according to claim 19 or 20,
**characterized in that** the pixel values of the jointly addressed pixels are averaged during the readout operation.

22. Method according to any one of claims 19 to 21,
**characterized in that** the pixels are selectively addressed with a digital decoder.

23. Method according to claim 22,
**characterized in that** the size and number of the groups of pixels to be addressed is fixed by the decoder.

24. Method according to any one of claims 19 to 23,
**characterized in that**, for a pixel arrangement in which the pixels are subject to a division into rows and columns, all pixels in a column or a row are separately addressed via a respective column line or row line.

25. Method according to claim 24,
**characterized in that** a selective and separate addressing of column lines or row lines is performed by means of a decoder circuit.

26. Method according to any one of claims 19 to 25,
**characterized in that**, for addressing a further central pixel in a given direction of propagation, new pixels are to be addressed in the propagation direction, and oppositely disposed pixels of the same colour class are replaced.

27. Method according to any one of claims 19 to 26,
**characterized in that** in addition to reading out a central pixel, any number of adjacent groups of pixels around the central pixel are addressed and read out, these pixels being subject in the same manner to a strictly cyclic sequence of the colour assignment.

28. Method according to any one of claims 19 to 27,
**characterized in that** during the readout operation at a given readout frequency, a weighting is performed on each readout line with an adjustable value.

29. Method according to claim 28,
**characterized in that** the weighting is performed according to the number of pixels simultaneously addressed on or connected to a readout line.

30. Method according to claim 28 or 29,
**characterized in that** the weighting is performed separately for the colour classes by means of adjustable coefficients.

**Revendications**

1. Unité de détection photosensible pour un appareil photo électronique, avec une disposition plane de pixels en forme de grille présentant des colonnes et des rangées qui sont adressables individuellement au moyen d'un décodeur d'adresses et qui sont reliées colonne par colonne à des lignes de lecture et peuvent être lues au moyen d'une unité de lecture, dans laquelle il est prévu dans chaque colonne au moins deux lignes de lecture qui sont reliées aux pixels disposés dans la colonne correspondante ainsi qu'à une unité de lecture de façon qu'un pixel central choisi puisse être lu de manière électriquement indépendante de, et simultanément avec, des pixels voisins formant ensemble un groupe, **caractérisée en ce que** le nombre de pixels voisins pouvant être lus simultanément est égal à six et **en ce que** les pixels sont structurés et disposés de telle sorte que le centre de gravité du pixel central coïncide avec le centre de gravité des pixels voisins pouvant être lus simultanément.

2. Unité de détection photosensible selon la revendication 1, **caractérisée en ce que** les pixels présentent une sortie de tension qui est reliée à une ligne de lecture et **en ce qu'**il est réalisé un moyennage du signal des pixels lus simultanément sur une ligne de lecture.

3. Unité de détection photosensible selon la revendication 1 ou la revendication 2, **caractérisée en ce que** des pixels individuels qui sont disposés dans une colonne commune et qui disposent d'un coefficient de pondération identique fixé pour chaque pixel peuvent être lus au moyen d'une ligne de lecture commune.

4. Unité de détection photosensible selon la revendication 3, **caractérisée en ce que** chaque ligne de lecture est reliée à un circuit de pondération dans lequel s'effectue la pondération des pixels lus.

5. Unité de détection photosensible selon l'une des revendications 2 à 4, **caractérisée en ce que** le moyennage du signal correspond à la moyenne géométrique des luminosités lorsqu'on utilise des pixels fonctionnant de manière logarithmique.

6. Unité de détection photosensible selon la revendication 4 ou la revendication 5, **caractérisée en ce que** les lignes de lecture sont connectées au circuit de pondération par un multiplexeur n parmi m.

7. Unité de détection photosensible selon l'une des revendications 4 à 6, **caractérisée en ce que** le circuit de pondération présente un premier étage de pondération dans lequel s'effectue une multiplication du signal lu par le nombre des pixels reliés à la ligne de lecture ainsi que par un coefficient qui correspond à la position des pixels lus simultanément dans le groupe.

8. Unité de détection photosensible selon l'une des revendications 2 à 7, **caractérisée en ce qu'**il est prévu un multiplexeur qui regroupe les lignes de lecture des pixels situés au voisinage, de préférence disposés concentriquement autour du pixel central et qui permet un moyennage des pixels placés de manière symétrique par rapport au pixel central.

9. Unité de détection photosensible selon l'une des revendications 1 à 8, **caractérisée en ce que** les pixels, pour réaliser un appareil photo couleurs, sont affectés aux couleurs de base rouge, vert et bleu ; **en ce que** la disposition des pixels et l'affectation des couleurs aux différents pixels sont choisies de telle sorte que le pixel central d'une couleur de base est immédiatement voisin, respectivement, des pixels des autres couleurs de base ; **en ce que** les pixels sont disposés selon une séquence strictement cyclique géométriquement parlant du point de vue de leur affectation à une couleur ; **en ce que** la séquence strictement cyclique de l'affectation à une couleur de pixels voisins respectifs est assurée dans toutes les directions de symétrie prédéterminées par la disposition géométrique des pixels ; et **en ce que** le circuit de pondération présente un deuxième étage de pondération qui effectue séparément une pondération en fonction des classes de couleur.

10. Unité de détection photosensible selon la revendication 9, **caractérisée en ce que** les signaux des classes de couleurs pondérées sont envoyés séparément les uns des autres à une unité de retraitement dans laquelle les signaux des différentes classes de couleurs sont pondérés et moyennés afin de former un signal de groupe de pixels.

11. Unité de détection photosensible selon l'une des revendications 1 à 10, **caractérisée en ce que** les pixels sont disposés selon une structure de grille hexagonale.

12. Unité de détection photosensible selon la revendication 11, **caractérisée en ce que** les pixels sont structurés et disposés de telle sorte que le centre de gravité du pixel central coïncide avec un centre de gravité commun défini par les pixels qui sont immédiatement voisins du pixel central et qui appartiennent à la même classe de couleur.

13. Unité de détection photosensible selon l'une des revendications 1 à 3, **caractérisée en ce que** les pixels ont une forme carrée, rectangulaire ou hexagonale.

14. Unité de détection photosensible selon la revendication 13, **caractérisée en ce que** la disposition des différents pixels correspond à une structure de grille obtenue par la superposition de deux grilles orthogonales, en forme de peigne, imbriquées l'une dans l'autre.

15. Unité de détection photosensible selon l'une des revendications 9 à 14, **caractérisée en ce qu'**il est prévu, pour l'affectation aux classes de couleurs, différentes couches filtrantes correspondant aux couleurs de base.

16. Unité de détection photosensible selon l'une des revendications 1 à 15, **caractérisée en ce que** l'unité de détection se compose de capteurs HDRC avec des pixels dont les signaux de sortie répondent à une caractéristique logarithmique.

17. Unité de détection photosensible selon la revendication 16, **caractérisée en ce que** les capteurs HDRC sont déposés sur un substrat porteur et présentent, sur leur face opposée au substrat porteur, une couche réduisant la réflexion.

18. Unité de détection photosensible selon l'une des revendications 11 à 17, **caractérisée en ce qu'**un groupe de pixels se compose d'un tuple de 7 disposant de 5 lignes de lecture disposées en colonnes et de 3 lignes de lecture disposées en rangées.

19. Procédé de lecture et de traitement de pixels dans une unité de détection photosensible selon l'une des revendications 9 à 18, **caractérisé en ce qu'**il est réalisé un adressage parallèle simultané d'au moins un groupe de pixels qui est disposé autour d'un pixel choisi, le pixel central, et **en ce qu'**une unité de lecture lit simultanément les pixels voisins en fonction de leur appartenance à une classe de couleur, le nombre des pixels voisins qui peuvent être lus simultanément étant égal à six et les pixels étant structurés de telle sorte que le centre de gravité du pixel central coïncide avec le centre de gravité des pixels voisins pouvant être lus simultanément.

20. Procédé selon la revendication 19, **caractérisé en ce que** le groupe se compose de pixels qui présentent respectivement un centre de gravité commun qui coïncide avec le centre de gravité du pixel central ou du moins se situe près du centre de gravité du pixel central.

21. Procédé selon la revendication 19 ou la revendication 20, **caractérisé en ce que** les valeurs des pixels adressés de manière conjointe sont moyennées au cours de l'opération de lecture.

22. Procédé selon l'une des revendications 19 à 21, **caractérisé en ce que** les pixels sont adressés de manière ciblée par l'intermédiaire d'un décodeur numérique.

23. Procédé selon la revendication 22, **caractérisé en ce que** la taille et le nombre des groupes de pixels à adresser sont fixés par le décodeur.

24. Procédé selon l'une des revendications 19 à 23, **caractérisé en ce que**, dans le cas d'une disposition des pixels dans laquelle les pixels présentent une répartition en rangées et colonnes, tous les pixels d'une colonne ou d'une rangée sont adressés séparément par l'intermédiaire d'une ligne de colonne ou d'une ligne de rangée.

25. Procédé selon la revendication 24, **caractérisé en ce qu'**il est réalisé un adressage ciblé et séparé des lignes de colonnes ou de rangées au moyen d'un circuit décodeur.

26. Procédé selon l'une des revendications 19 à 25, **caractérisé en ce que**, pour l'adressage d'un autre pixel central dans un sens de propagation prédéterminé, il faut adresser de nouveaux pixels dans le sens de propagation et les pixels de la même classe de couleur disposés en sens contraire sont remplacés.

27. Procédé selon l'une des revendications 19 à 26, **caractérisé en ce que**, après la lecture d'une pixel central, il est réalisé en plus un adressage et une lecture d'un nombre quelconque de groupes de pixels voisins qui entourent le pixel central et qui présentent également une séquence cyclique stricte de l'affectation à une couleur.

28. Procédé selon l'une des revendications 19 à 27, **caractérisé en ce que**, pendant l'opération de lecture à une fréquence de lecture prédéterminée, il est réalisé sur chaque ligne de lecture une pondération effectuée avec une valeur réglable.

29. Procédé selon la revendication 28, **caractérisé en ce que** la pondération se fait en fonction du nombre de pixels adressés ou reliés simultanément à une ligne de lecture.

30. Procédé selon la revendication 28 ou la revendication 29, **caractérisé en ce que** la pondération se fait séparément pour les classes de couleurs au moyen de coefficients réglables.

# FIG 1

| | | | | |
|---|---|---|---|---|
| R | G | R | G | R |
| G | B | G | B | G |
| R | G | R | G | R |
| G | B | G | B | G |
| R | G | R | G | R |

Bayer

| | | | | |
|---|---|---|---|---|
| R | G | B | G | R |
| B | G | R | G | B |
| R | G | B | G | R |
| B | G | R | G | B |
| R | G | B | G | R |

Old Sony

| | | | | |
|---|---|---|---|---|
| R | G | B | G | R |
| R | G | B | G | R |
| R | G | B | G | R |
| R | G | B | G | R |
| R | G | B | G | R |

Sony Mavica

| | | | | |
|---|---|---|---|---|
| C | M | C | M | C |
| M | Y | M | Y | M |
| C | M | C | M | C |
| M | Y | M | Y | M |
| C | M | C | M | C |

CMY

| | | | | |
|---|---|---|---|---|
| G | W | G | W | G |
| Y | C | Y | C | Y |
| G | W | G | W | G |
| Y | C | Y | C | Y |
| G | W | G | W | G |

Hitachi

| | | | | |
|---|---|---|---|---|
| R | G | B | R | G |
| G | B | R | G | B |
| B | R | G | B | R |
| R | G | B | R | G |
| G | B | R | G | B |

RGB staggere

# FIG 2

# FIG 3

| | | | | |
|---|---|---|---|---|
| R | G | B | R | G |
| G | B | R | G | B |
| R | G | B | R | G |
| G | B | R | G | B |
| R | G | B | R | G |

**FIG 4**

FIG 5A

| R | G | B | R | G |

| G | B | R | G | B |

| R | G | B | R | G |

| G | B | R | G | B |

| R | G | B | R | G |

| R | G |

| G | B | R |

| R | G |

"B" col pix

FIG 5B

| R | G | B | R | G |

| G | B | R | G | B |

| R | G | B | R | G |

| G | B | R | G | B |

| R | G | B | R | G |

| G | B |

| B | R | G |

| G | B |

"R" col pix

FIG 5C

| R | G | B | R | G |

| G | B | R | G | B |

| R | G | B | R | G |

| G | B | R | G | B |

| R | G | B | R | G |

| B | R |

| R | G | B |

| B | R |

"G" col pix

# FIG 6

# FIG 7

FIG 8